# EUROPEAN PATENT SPECIFICATION

(11) **EP 4 352 466 B1**
(45) Date of publication and mention of the grant of the patent: **03.06.2026**
(21) Application number: 22722726.1
(22) Date of filing: 13.04.2022
(51) Int. Cl.: G01G 7/02

(54) **APPARATUS COMPRISING A WEIGHING DEVICE**
GERÄT MIT EINER WÄGEEINRICHTUNG
DISPOSITIF AVEC UNE UNITÉ DE PESAGE

(30) Priority: 09.06.2021 GB 202108212
(43) Date of publication of application: 17.04.2024
(73) Proprietor: Lam Research Corporation, Fremont, CA 94538 (US)
(72) Inventor: OWENS, Sam, Caldicot Gwent NP26 4LW (GB); ELLIOTT, Gregor Robert, Gloucester Gloucestershire GL15 5SF (GB); RAMAKRISHNAN, Vivek, Bristol Bristol BS32 9DW (GB); COELHO, Luis, Bristol Bristol BS10 7FD (GB); SAXENA, Prashant, Stonehouse Gloucestershire GL10 3FJ (GB)
(74) Representative: Mewburn Ellis LLP
(86) International application number: PCT/EP2022/059850
(87) International publication number: WO 2022/258245

(56) References cited:
- WO-A1-2009/112821
- WO-A1-2021/073982

## Description

### Field of the invention

The present invention relates to an apparatus comprising a weighing device for generating measurement output indicative of the weight of an object loaded on the weighing device, such as a semiconductor wafer.

### Background of the invention

Microelectronic devices are fabricated on semiconductor (e.g. silicon) wafers using a variety of techniques, e.g. including deposition techniques (CVD, PECVD, PVD, etc.) and removal techniques (e.g. chemical etching, CMP, etc.). Semiconductor wafers may be further treated in ways that alter their mass, e.g. by cleaning, ion implantation, lithography and the like.

Depending on the device being manufactured, each semiconductor wafer may be passed sequentially through hundreds of different processing steps to build up and/or to remove the layers and materials necessary for its ultimate operation. In effect, each semiconductor wafer is passed down a production line. The nature of semiconductor manufacturing means that certain processing steps or sequences of steps in the production flow may be repeated in a similar or identical fashion. For example, this may be to build up similar layers of metal conductors to interconnect different parts of the active circuitry.

To ensure consistency and interoperability of semiconductor equipment used in different factories, standards are adopted throughout the majority of the semiconductor manufacturing industry. For example, standards developed by Semiconductor Equipment and Materials International (SEMI) have a high degree of market uptake. One example of standardisation is the size and shape of the semiconductor (silicon) wafers: typically for volume production they are discs having a diameter of 300 mm. However, some semiconductor (silicon) wafers (typically used in older factories) are discs having a diameter of 200 mm.

The cost and complexity of the processing steps required to produce a completed silicon wafer together with the time that it takes to reach the end of the production line where its operation can be properly assessed has led to a desire to monitor the operation of the equipment on the production line and the quality of the wafers being processed throughout processing, so that confidence in the performance and yield of the final wafers may be assured.

Wafer treatment techniques typically cause a change in mass at or on the surface of the semiconductor wafer. The configuration of the changes to the surface are often vital to the functioning of the device, so it is desirable for quality control purposes to assess wafers during production in order to determine whether they have the correct configuration.

Specialist metrology tools may be used within the production flow so that monitoring is conducted soon after the relevant process of interest and usually before any subsequent processing, i.e. between processing steps.

Measuring the change in mass of a wafer either side of a processing step is an attractive method for implementing product wafer metrology. It is relatively low cost, high speed and can accommodate different wafer circuitry patterns automatically. In addition, it can often provide results of higher accuracy than alternative techniques. For example, on many typical materials, thicknesses of material layers can be resolved down to an atomic scale. The wafer in question is weighed before and after the processing step of interest. The change in mass is correlated to the performance of the production equipment and/or the desired properties of the wafer.

More accurate measurement of the change in mass of a wafer allows for tighter quality control of the wafer processing.

The mass of a wafer can be measured by firstly loading the wafer on a load cell. When the wafer is loaded on the load cell, the output of the load cell will wander before settling on a stable value. The stable value can then be converted to a mass value via the application of a buoyancy calculation.

However, if the same wafer is repeatedly placed on the same load cell, the stable value at which the output of the load cell settles will be different each time, due to variable errors in the output of the load cell.

It is desirable to reduce the variable errors in the output of the load cell, to allow more accurate measurement of the change in mass of the wafer.

Variability in the output of the load cell can be reduced by performing multiple measurements on the wafer and averaging the output of the load cell over the multiple measurements.

However, once the output of the load cell has settled on a stable value, the output of the load cell remains the same while the wafer is loaded on the load cell. In other words, the output of the load cell locks once it has become stable. Therefore, if multiple measurements are performed while the wafer is loaded on the load cell and the output has stabilised, the output of the load cell will be the same for all of the measurements and averaging the measurements will not reduce the variable errors in the output of the load cell.

Therefore, in order to reduce the variable errors in the output of the load cell by averaging the output of the load cell over multiple measurements, it is currently necessary to remove the wafer from the load cell between each measurement, and to allow the output of the load cell to return to zero before reloading the wafer on the load cell to perform the next measurement.

With this approach, the value at which the output of the load cell stabilises will be different for each measurement, due to the variable errors in the output of the load cell, and the variable errors can be reduced by averaging the output of the load cell over the multiple measurements.

WO2009/112821A1 discloses metrology methods and apparatus for semiconductor wafer fabrication in which data for metrology is obtained by detecting a measurable property of a monitored entity, which is either (i) a wafer transporter (e.g. a FOUP) loaded with one or more wafers to be monitored, or (ii) a plurality of wafers. Performing metrology measurements on a loaded wafer transporter enables the step of extracting wafer(s) from the transporter for metrology measurements to be omitted. Moreover, metrology measurement may be obtained while transporting the wafer(s) between treatment locations. By considering a plurality of wafers as a unit, a single measurement representing a combination of individual wafer responses is obtained. All wafers contribute to the metrology measurement without the need to perform individual wafer measurements.

WO2021/073982A1 discloses a weighing device, e.g. for kitchens. It has a support plate, on which the object being measured is placed, and a controller. An excitation element for generating mechanical vibrations in the support plate and a measuring element for measuring the mechanical vibrations of the support plate are also provided. The excitation element and the measuring element are used to determine one or more resonance frequencies and/or other spectral properties of the support plate, and these are used, for example, to determine the mass.

### Summary of the invention

The present inventors have realised that while the approach described above is effective at reducing the variable errors in the output of the load cell, it is time consuming and therefore affects wafer throughput.

In particular, the procedure of lifting the wafer off the load cell, waiting for the reading to return to zero, loading the wafer back on the load cell, and waiting for the output of the load cell to stabilise, between each measurement is time consuming.

The present invention may provide a less time-consuming approach for reducing the variable errors in the output of the load cell.

The present inventors have realised that although the output of the load cell appears to lock at a stable value once the output has stabilised, if the wafer and/or load cell are sufficiently disturbed, the measurement output will change and will then stabilise at a different stable value due to the variable errors in the output of the load cell.

The present inventors have realised that multiple measurements that can be averaged to reduce the variable errors in the output of the load cell can therefore be obtained more rapidly by temporarily and controllably disturbing the measurement output of the weighing device while the semiconductor wafer is loaded on the weighing device.

In particular, temporarily disturbing the measurement output of the weighing device while the semiconductor wafer is loaded on the weighing device is significantly quicker than lifting the wafer off the load cell, waiting for the reading to return to zero, loading the wafer back on the load cell, and waiting for the output of the load cell to stabilise at a new value.

Of course, this approach is also applicable to weighing objects other than a semiconductor wafer. References to wafer or semiconductor wafer below may therefore be replaced with the term object, where appropriate.

This approach may be applicable to weighing devices including different types of force sensor, force transducer, or load cell.

A load cell may mean a force sensor or force transducer configured to convert a force applied to the force sensor or force transducer into an electrical signal that corresponds to the force.

Therefore, at its most general the present invention relates to providing a weighing device with means for temporarily disturbing an output of the weighing device while an object is loaded on the weighing device.

According to a first aspect of the present invention there is provided an apparatus as specified in claim 1.

The apparatus according to the present invention may have any one, or, where compatible, any combination of the following optional features.

The term object may be replaced with the term article or item.

The object may be a wafer-shaped article, for example a wafer, such as a semiconductor wafer.

The apparatus may be for determining information relating to, or indicative of, the weight of an object, or for determining information relating to, or indicative of, the mass of an object.

The apparatus may be for determining the weight of an object.

The apparatus may be for determining the mass of an object, or the difference between the mass of the object and a reference mass.

Measurement output indicative of the weight of the object may mean a measured weight of the object, or a measured difference between the weight of the object and the weight of another article, such as a reference weight.

The measurement output may be the weight of the object, or the difference between the weight of the object and the weight of another article, such as a reference weight.

Measurement output indicative of the weight of the object may mean measurement output corresponding to the weight of the object.

Generating measurement output indicative of the weight of an object loaded on the weighing device may comprise performing a weight measurement on the object loaded on the weighing device, or a weight force measurement on the object loaded on the weighing device.

The weighing device may have a measurement area on which the object is loaded, for example a pan such as a balance pan or weighing pan.

The weighing device may be configured to, or adapted to, generate the measurement output indicative of the weight of the object loaded on the weighing device.

The disturbance element may be configured to, or adapted to, temporarily disturb the measurement output of the weighing device while the object is loaded on the weighing device.

The weighing device may have a pan such as a balance pan (or weighing pan) for supporting the object during a measurement performed by the weighing device.

The weighing device may comprise or be a microbalance.

The weighing device may comprise or be a weighing balance.

The weighing device may comprise or be an electronic balance.

The weighing device may comprise a force sensor or force transducer for generating measurement output indicative of the weight of an object loaded on the weighing device.

The weighing device may comprise a weight force sensor or weight force transducer for generating measurement output indicative of the weight of an object loaded on the weighing device.

The weighing device may comprise a load cell for generating measurement output indicative of the weight of an object loaded on the weighing device.

The measurement area (for example pan) may be connected or coupled to the force sensor, force transducer, weight force sensor, weight force transducer or load cell, so that a weight force of an object loaded on the measurement area is transmitted from the measurement area to the force sensor, force transducer, weight force sensor, weight force transducer or load cell.

The weighing device may generate the measurement output based on a measurement of an amount of electromagnetic force compensation required to compensate for (or counterbalance) a weight loaded on the weighing device.

The weighing device may be configured to balance the weight force of the object with a force experienced when an electromagnetic coil of the weighing device is energised in a magnetic field of the weighing device. Specifically, the weighing device may be configured to provide a current to the electromagnetic coil that is sufficient to cause the force experienced by the electromagnetic coil to balance the weight force of the object. The measurement output of the weighing device may be generated based on the required current. The weighing device may therefore comprise an electromagnetic coil arranged in a magnetic field.

The weighing device may comprise an electromagnetic force compensation or electromagnetic force restoration force sensor or load cell comprising an electromagnetic coil.

The electromagnetic coil may be wound around a core, such as a ferromagnetic core.

The term electromagnet may mean an electromagnetic coil, or an electromagnetic coil wound around a core, such as a ferromagnetic core.

Disturbing the measurement output of the weighing device may mean causing the measurement output to change or vary.

In particular, disturbing the measurement output of the weighing device may mean causing the measurement output to change or vary without the measurement output returning to zero or another predetermined measurement output generated by the weighing device when no object is loaded on the weighing device.

The disturbance element controllably disturbs the measurement output of the weighing device.

The apparatus may comprise a controller for controlling (or configured or adapted to control) the disturbance element to controllably and temporarily disturb the measurement output of the weighing device.

Disturbing the measurement output of the weighing device may mean disrupting the measurement output, or interfering with the measurement output, or interrupting the measurement output, or perturbing the measurement output, or changing the measurement output, or altering the measurement output.

The disturbance element may be a disturbance arrangement, or disturbance mechanism, or disturbance article, or disturbance part, or disturbance means.

Disturbing the measurement output of the weighing device while the object is loaded on the weighing device means that the measurement output is disturbed without removing the object from the weighing device. In other words, the object is loaded on the weighing device during the disturbance of the measurement output.

Many different methods of disturbing the measurement output of the weighing device are possible, and the present invention is not limited to a specific method of disturbing the measurement output. Some example approaches are discussed below, but the present invention is not limited to these specific examples.

The disturbance element may comprise an actuator, for example an electrical or pneumatic actuator.

The disturbance element may comprise a contact element configured to temporarily contact the weighing device and/or the object. The contact element may be movable, for example by an actuator, to cause the contact element to temporarily contact the weighing device and/or the object. The apparatus may therefore comprise an actuator configured to move the contact element to temporarily contact the weighing device and/or the object. The apparatus may comprise a controller configured to control the contact element to move so as to temporarily contact the weighing device and/or the object.

For example, the contact element may comprise a pin or rod for temporarily contacting the weighing device and/or the object.

The disturbance element may be configured to disturb the object loaded on the weighing device.

For example, the disturbance element may be configured to cause movement of the object loaded on the weighing device.

For example, the disturbance element may comprise a contact element that is movable, for example by an actuator of the apparatus, to temporarily contact the object loaded on the weighing device so as to cause movement of the object. The apparatus may comprise a controller configured to control the contact element to move so as to temporarily contact the object loaded on the weighing device so as to cause movement of the object.

In addition, or alternatively, the disturbance element may be configured to apply a force to the object loaded on the weighing device.

For example, the disturbance element may comprise a contact element that is movable, for example by an actuator of the apparatus, to temporarily contact the object to apply a force to the object. The apparatus may comprise a controller configured to control the contact element to move so as to temporarily contact the object to apply a force to the object.

The disturbance element may be configured to apply a force to the object in a direction of the weight force of the object, or at least partly in the direction of the weight force of the object, so as to increase the total force measured by the weighing device. For example, the disturbance element may comprise a contact element that is movable, for example by an actuator of the apparatus, to temporarily apply a force to a top of the object (a surface of the object opposite to the weighing device).

Alternatively, the disturbance element may be configured to apply a force to the object in a direction opposite to the weight force of the object, or at least partly in the direction opposite to the weight force of the object, so as to decrease the total force measured by the weighing device. For example, the disturbance element may comprise a contact element that is movable, for example by an actuator of the apparatus, to temporarily apply a force to a bottom of the object (facing the weighing device).

The disturbance element may be configured to disturb the weighing device, or part of the weighing device.

For example, the disturbance element may be configured to disturb a measurement area such as a pan (balance pan or weighing pan) of the weighing device, and/or a force sensor, force transducer or load cell of the weighing device.

For example, the disturbance element may be configured to cause movement of the weighing device or part of the weighing device.

For example, the disturbance element may comprise a contact element that is movable, for example by an actuator of the apparatus, to temporarily contact the weighing device or part of the weighing device so as to cause movement of the weighing device or part of the weighing device. The apparatus may comprise a controller configured to control the contact element to move so as to temporarily contact the weighing device or part of the weighing device so as to cause movement of the weighing device or part of the weighing device.

In addition, or alternatively, the disturbance element may be configured to apply a force to the weighing device or part of the weighing device.

For example, the disturbance element may be configured to temporarily apply a force to a measurement area of the weighing device, such as a pan, or to a force sensor, force transducer or load cell of the weighing device. In particular, the disturbance element may comprise a contact element that is movable, for example by an actuator, to temporarily contact the part of the weighing device to apply a force to the part of the weighing device. The apparatus may comprise a controller configured to control the contact element to move so as to temporarily contact the part of the weighing device to apply a force to the part of the weighing device.

The force applied to the weighing device or part of the weighing device may be arranged to increase a weight force measured by the weighing device or to decrease a weight force measured by the weighing device.

The disturbance element may be configured to temporarily apply a force to a measurement area of the weighing device, for example a balance pan, in a direction of the weight force of the object, or at least partly in the direction of the weight force of the object, so as to increase the force measured by the weighing device. For example, the disturbance element may comprise a contact element that is movable, for example by an actuator of the apparatus, to temporarily apply a force to a top of the measurement area. The apparatus may comprise a controller configured to control the contact element to move so as to temporarily apply a force to a top of the measurement area.

Alternatively, the disturbance element may be configured to temporarily apply a force to the measurement area in a direction opposite to the weight force of the object, or at least partly in the direction opposite to the weight force of the object, so as to decrease the total force measured by the weighing device. For example, the disturbance element may comprise a contact element that is movable, for example by an actuator, to temporarily apply a force to a bottom of the measurement area. The apparatus may comprise a controller configured to control the contact element to move so as to temporarily apply a force to a bottom of the measurement area.

The disturbance element may be configured to alter a total weight loaded on the weighing device. For example, the disturbance element may temporarily support part of the weight of the object, or temporarily apply a force to the object to increase a loading force on the weighing device. This may be achieved by the disturbance element comprising a contact element that is movable, for example by an actuator of the apparatus, to temporarily contact the object and apply a force to the object. The apparatus may comprise a controller configured to control the contact element to move so as to temporarily contact the object and apply a force to the object. Alternatively, the disturbance element may internally or externally load additional weight on the weighing device. This may be achieved by the disturbance element comprising an additional weight that is loaded on to a measurement area of the weighing device by a loading mechanism. The disturbance element may therefore comprise a weight and a loader for loading and unloading the weight on the weighing device, for example by loading and unloading the weight on a measurement area of the weighing device. The apparatus may comprise a controller configured to control the loader so as to load and unload the weight on the weighing device.

The disturbance element may comprise a lifting pin that lifts part of the weight of the object. For example, the lifting pin may be movable, for example by an actuator of the apparatus, to temporarily contact an underside of the object and to apply a lifting force to the object to counteract part of the weight force of the object. The apparatus may comprise a controller configured to control the lifting pin to move so as to temporarily contact an underside of the object and to apply a lifting force to the object. The lifting pin may lift only part of the weight of the object so that the object remains loaded on the weighing device.

The disturbance element may comprise an element or actuator that provides an impulse to the object and/or weighing device, for example by impacting the object and/or weighing device (for example a force sensor or load cell of the weighing device).

For example, the disturbance element may comprise a contact element or impact element that is movable, for example by an actuator of the apparatus, to temporarily contact or impact the object and/or weighing device to provide an impulse to the object and/or weighing device. As discussed above, the impulse may be applied at least partly in the direction of the weight force of the object, or at least partly in a direction opposite to the weight force of the object. The apparatus may comprise a controller configured to control the contact element or impact element to move so as to temporarily contact or impact the object and/or weighing device to provide an impulse to the object and/or weighing device.

The weighing device may comprise an electromagnetic coil; and the disturbance element may comprise a magnet or electromagnetic coil that is useable or operable to disturb the electromagnetic coil of the weighing device.

The weighing device may comprise a load cell that comprises the electromagnetic coil of the weighing device.

The magnet may be a permanent magnet that can be moved closer to, or further away from the electromagnetic coil. For example, the disturbance element may comprise an actuator for moving the magnet closer to, or further away from, the electromagnetic coil of the weighing device. The apparatus may comprise a controller configured to control the magnet to move closer to, or further away from, the electromagnetic coil. Alternatively, the magnet may be an electromagnet. For example, the electromagnet may be arranged around the electromagnetic coil of the weighing device. The disturbance element may therefore comprise a power supply for selectively supplying a current to the electromagnet. The apparatus may comprise a controller configured to control the power supply to selectively and/or temporarily supply a current to the electromagnet. Where the disturbance element comprises an electromagnetic coil, the electromagnetic coil may be wound around, or positioned or located around, the electromagnetic coil of the weighing device. The disturbance element may therefore comprise a power supply for selectively supplying a current to the electromagnetic coil of the disturbance element. The apparatus may comprise a controller configured to control the power supply to selectively and/or temporarily supply a current to the electromagnetic coil.

The weighing device may comprise a load cell, and the magnet may be an electromagnet that surrounds the load cell when the electromagnet is energised. The measurement output of the weighing device may therefore be temporarily disturbed by temporarily energising the electromagnet.

The weighing device may comprise a load cell. The disturbance element may comprise a magnet (for example a permanent magnet or an electromagnet) or an electromagnetic coil that is useable to disturb the load cell. For example, the apparatus may comprise a controller configured to temporarily supply current to the electromagnetic coil so as to disturb the load cell. In addition, or alternatively, the apparatus may comprise an actuator for moving the magnet or electromagnetic coil closer to, or further away from, the load cell so as to disturb the load cell. The apparatus may comprise a controller configured to control the movement of the magnet or electromagnetic coil.

The load cell may comprise an electromagnetic coil, for example as described above.

The weighing device may balance the downward force of the object weight against a force experienced when the electromagnetic coil is energised in a magnetic field. Disturbing the electromagnetic coil using the magnet or electromagnetic coil will therefore disturb the measurement output of the weighing device.

For example, the weighing device may comprise an electromagnetic force compensation or electromagnetic force restoration force sensor or load cell comprising an electromagnetic coil.

The disturbance element may comprise a mechanism for temporarily loading additional weight on the weighing device.

The disturbance element may comprise a blower, such as a fan, for blowing air at or on the object. The apparatus may comprise a controller configured to selectively and/or temporarily activate the blower to blow air at or on the object.

The apparatus or weighing device may comprise a measurement chamber; and the disturbance element may comprise a mechanism for disturbing air in the measurement chamber.

For example, the disturbance element may comprise a blower, such as a fan, for blowing air inside the measurement chamber.

The disturbance element may comprise a controller configured to temporarily open and subsequently close a lid of the measurement chamber to disturb the air in the measurement chamber. The apparatus may therefore comprise a measurement chamber that encloses the weighing device, wherein a lid of the measurement chamber is openable or removable. The apparatus may further comprise one or more actuators for opening or removing the lid of the measurement chamber. The apparatus may comprise a controller configured to control the lid to be opened or removed while the object is loaded on the weighing device to temporarily disturb the measurement output of the weighing device. The controller may then control the lid to be closed or replaced before a further measurement output is recorded.

The disturbance element may comprise a mechanism for vibrating the weighing device and/or the object.

The mechanism may comprise a vibrator and/or an actuator for vibrating the weighing device and/or the object.

For example, the vibrator may be movable by an actuator of the apparatus to temporarily contact the weighing device (for example a measurement area of the weighing device) or the object and cause it to vibrate. Alternatively, the vibrator may be in contact with part of the weighing device, and may be selectively and/or temporarily activated to vibrate part of the weighing device and/or the object. The apparatus may comprise a controller configured to control movement and/or activation of the vibrator.

The disturbance element may comprise a mechanism for moving the part of the weighing device. For example, the disturbance element may move a load cell or electromagnetic coil of the weighing device. This may be achieved by the disturbance element comprising a contact element that is movable by an actuator of the apparatus to contact the part of the weighing device. The apparatus may comprise a controller configured to control movement of the contact element. Alternatively, the apparatus may comprise an actuator attached to, or coupled to, or connected to, the part of the weighing device that is operable to move the part of the weighing device. The apparatus may comprise a controller configured to control movement of the part of the weighing device.

The disturbance element may comprise a mechanism for mechanically disturbing the object and/or the weighing device. Mechanically disturbing the object and/or the weighing device may mean physically contacting the object and/or the weighing device to move and/or alter a configuration of the object and/or the weighing device. This may be achieved with a contact element and actuator as discussed above.

The disturbance element may comprise a device for temporarily interrupting or changing a power supply to the weighing device. For example, the disturbance element may comprise a switch for interrupting the power supply to the weighing device. The device may temporarily interrupt or change power to a load cell or electromagnetic coil of the weighing device. Interrupting the power supply may mean temporarily disconnecting, or temporarily switching off, the power supply. The apparatus may comprise a controller configured to control temporary interruption of the power supply to the weighing device. For example, the controller may control the switch to open to temporarily interrupt the power supply to the weighing device, and to subsequently close to no longer interrupt the power supply.

The disturbance element may comprise a controller configured to reset or interrupt a stability algorithm of the weighing device. The stability algorithm may be software that stabilises the output of the weighing device when an object is loaded on the weighing device. Therefore, resetting or interrupting the stability algorithm may disturb the output of the weighing device.

The weighing device may comprise a position sensor for detecting a position of part of the weighing device; and the disturbance element may comprise a mechanism for optically or mechanically disturbing the position sensor.

The weighing device may comprise an electromagnetic coil, and the position sensor may detect a position of the electromagnetic coil or another part of the weighing device that moves with the electromagnetic coil.

The weighing device may comprise a load cell comprising the electromagnetic coil.

For example, the weighing device may balance the downward force of the object weight against a force experienced when an electromagnetic coil is energised in a magnetic field. The position sensor may detect a position of the electromagnetic coil or another part of the weighing device that moves with the electromagnetic coil.

The position sensor may use electromagnetic radiation, such as visible light to detect the position. For example, the position sensor may comprise a light source (or other electromagnetic radiation source) and a light sensor (or other electromagnetic radiation sensor), wherein movement of the electromagnetic coil causes a change in the intensity of light (or other electromagnetic radiation) detected by the light sensor.

Mechanically disturbing the position sensor may comprise physically blocking (or partly blocking) a sensing path of the position sensor, or moving a light sensor part of the position sensor, or moving a light source part of the position sensor, for example. Optically disturbing the position sensor may comprise providing additional light to the light sensor, for example.

The apparatus may comprise a controller configured to control the mechanism to temporarily optically or mechanically disturb the position sensor.

The weighing device may comprise a load cell (or force sensor, or force transducer). The apparatus may comprise a circuit for suppling power to the load cell. The disturbance element may comprise a mechanism or arrangement or device or part for temporarily changing an electrical property of the circuit.

The weighing device may comprise the circuit.

The disturbance element may comprise a mechanism or arrangement or device or part for temporarily changing an electrical property of the circuit so as to change a current flowing through the load cell.

For example, the disturbance element may comprise a mechanism or arrangement or device or part for temporarily increasing an electrical load, resistance, capacitance or inductance of the circuit, or for temporarily decreasing the electrical load, resistance, capacitance or inductance of the circuit.

The disturbance element may comprise a mechanism or arrangement or device or part for temporarily introducing an additional load, resistance, capacitance or inductance into the circuit, for example by temporarily adding an additional load, resistance, capacitance or inductance into the circuit.

Alternatively, the disturbance element may comprise a mechanism or arrangement or device or part for temporarily removing a load, resistance, capacitance or inductance from the circuit, for example by temporarily disconnecting a load, resistance, capacitance or inductance from the circuit.

The addition or removal of a load, resistance, capacitance or inductance from the circuit may be controlled by a controller of the apparatus so as to disturb the measurement output of the weighing device.

Alternatively, the disturbance element may comprise a controller of the apparatus that is configured to temporarily adjust a load, resistance, capacitance or inductance of a variable load, variable resistor, variable capacitor, or variable inductor in the circuit.

The weighing device may comprise a load cell (or force sensor, or force transducer). The disturbance element may comprise an electronic component and a switch that are connected in parallel to the load cell.

The switch may be closed to connect the electrical component in parallel to the load cell, and opened to disconnect the electrical component in parallel to the load cell.

The switch may be a relay, for example. The switch may be controllable by a controller to open or close the switch. The switch may be controlled via a wired connection or via a wireless connection.

The apparatus may comprise a controller configured to close the switch so as to temporarily disturb the output of the weighing device while the object is loaded on the weighing device. The controller may be configured to subsequently open the switch before a further measurement output is recorded.

The electronic component and switch may be included in a circuit for supplying power to the load cell.

The electronic component may comprise a load, a resistor, a capacitor, or an inductor. Of course, more than one of these electronic components may be included, and/or a different type or types of electronic component may be included.

The electronic component and the switch are connected in series (in any order), and the series connection of the electronic component and the switch is connected in parallel to the load cell.

Therefore, when the switch is closed, the electronic component is connected in parallel with the load cell, and a current flowing through the load cell will be reduced (due to current flowing through the electronic component). In contrast, when the switch is open, current cannot flow through the electronic component and a current flowing through the load cell will therefore not be reduced.

Therefore, by temporarily closing the switch, a current flowing through the load cell can be temporarily decreased. This may disturb the measurement output of the weighing device. When the switch is then opened, the measurement output of the weighing device may then settle on a new stable measurement output.

The load cell may comprise an electromagnetic coil, and the circuit may be for supplying current to the electromagnetic coil.

The electronic component and the switch may be connected in parallel to the electromagnetic coil.

The weighing device may comprise an electromagnetic force compensation or electromagnetic force restoration force sensor or load cell in which current is supplied to an electromagnetic coil while the electromagnetic coil is in an external magnetic field so that a force experienced by the electromagnetic coil balances out the weight force of the object loaded on the weighing device. If the current flowing through the electromagnetic coil is temporarily decreased by closing the switch, the measurement output of the weighing device will be disturbed.

The circuit may comprise a power supply or current supply for supplying power or current to the load cell.

The apparatus according to the first aspect of the present invention comprises a controller configured to: record a stable measurement output of the weighing device with the object loaded on the weighing device; control the disturbance element to temporarily disturb the measurement output of the weighing device with the object loaded on the weighing device; and record a subsequent stable measurement output of the weighing device with the object loaded on the weighing device.

The controller may be configured to average the stable measurement output and the subsequent stable measurement output.

The controller may be configured to: repeat the steps of controlling the disturbance element and recording the subsequent stable measurement output a plurality of times; and average at least some of the stable measurement output and the subsequent stable measurement outputs.

The apparatus may comprise a controller configured to calculate the mass of the object based on the measurement output.

The controller may be configured to convert the measurement output to a mass value via the application of a buoyancy calculation.

The disturbance element may be included inside the weighing device, or may be external to the weighing device.

References to a controller above may be to a single controller that performs multiple functions, or to more than one controller.

According to a second aspect of the present invention there is provided a method as specified in claim 14.

The method according to the second aspect of the present invention may have any of the features of the apparatus of the present invention described above or below, unless incompatible.

For example, the weighing device may have any of the features of the weighing device described above or below.

The measurement output of the weighing device may be temporarily disturbed using a disturbance element. The disturbance element may have any of the features of the disturbance element described above or below.

The method according to the second aspect of the present invention comprises recording a stable measurement output of the weighing device with the object loaded on the weighing device; temporarily disturbing the measurement output of the weighing device while the object is loaded on the weighing device; and recording a subsequent stable measurement output of the weighing device with the object loaded on the weighing device.

The method may comprise calculating an average measurement output based on at least the stable measurement output and the subsequent stable measurement output.

The method may comprise repeating the steps of temporarily disturbing the measurement output and recording the subsequent stable measurement output a plurality of times; and averaging at least some of the stable measurement output and the subsequent stable measurement outputs.

### Brief description of the drawings

Embodiments of the present invention will now be discussed, by way of example only, with reference to the accompanying Figures, in which:
FIG. 1 is a schematic illustration of a conventional electronic balance that can be used in embodiments of the present invention;
FIG. 2 is a schematic illustration of a conventional electronic balance that can be used in embodiments of the present invention;
FIG. 3 is a schematic illustration of an apparatus according to an embodiment of the present invention; and
FIG. 4 is a schematic illustration of an apparatus according to a further embodiment of the present invention.

### Detailed description of the preferred embodiments and further optional features of the invention

Aspects and embodiments of the present invention will now be discussed with reference to the accompanying figures. Further aspects and embodiments will be apparent to those skilled in the art.

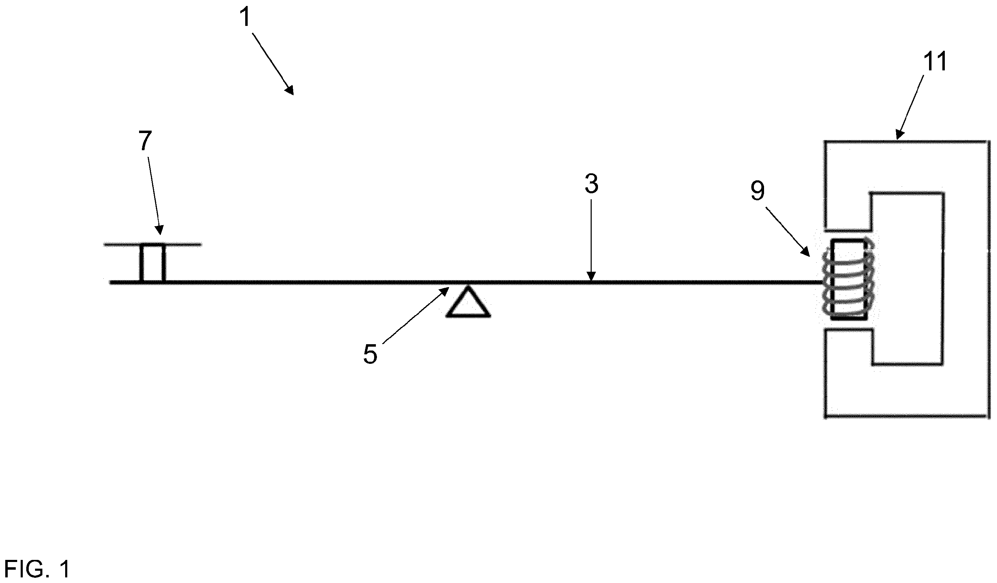

FIG. 1 is a simplified schematic illustration of the principle components of a conventional electronic balance that can be used in embodiments of the present invention.

As shown in FIG. 1, the conventional electronic balance 1 comprises a balance beam 3. The balance beam 3 can be pivoted at a pivot point 5, e.g. a knife edge. A balance pan 7 is positioned on the balance beam 3 on a first side of the pivot point 5. On a second side of the pivot point 5, an electromagnet or electromagnetic coil 9 is positioned on the balance beam 3. The electromagnet or electromagnetic coil 9 is located within the magnetic field of a magnet 11. The magnet 11 may be a permanent magnet, or an electromagnet.

In use of the conventional electronic balance 1, an object whose weight is to be measured, for example a semiconductor wafer, is placed on the balance pan 7. The weight of the object on the balance pan 7 causes a moment of force on the balance beam 3 that acts to rotate the balance beam 3 in an anti-clockwise direction around the pivot point 5. Rotation of the balance beam 3 in an anti-clockwise direction around the pivot point 5 would cause the electromagnet or electromagnetic coil 9 to move upwards.

When an electrical current is supplied to the electromagnet or electromagnetic coil 9, the electromagnet or electromagnetic coil 9 produces a magnetic field. The interaction between the magnetic field produced by the electromagnet or electromagnetic coil 9 and the magnetic field produced by the magnet 11 causes the electromagnet or electromagnetic coil 9 to experience a force, the magnitude and direction of which is determined by the magnitude and direction of the current applied to the electromagnet or electromagnetic coil 9.

By applying a current with a suitable magnitude and direction to the electromagnet or electromagnetic coil 9, the electromagnet or electromagnetic coil 9 can be made to experience a downwards force that causes a moment of force on the balance beam 3 that is equal and opposite to the moment of force caused by the weight of the object on the balance pan 7 (i.e. a moment of force in the clockwise direction in FIG. 1). In that case, the electromagnet or electromagnetic coil 9 will stay stationary and will not move upwards, because the two moments of force acting on the balance beam cancel out, meaning that there is no resultant moment of force.

The downwards force on the electromagnet or electromagnetic coil 9, and therefore the moment of force caused by the downwards force, depends on the magnitude of the current applied to the electromagnet or electromagnetic coil 9. Therefore, the moment of force caused by the weight of the object on the balance pan 7 can be determined by measuring the magnitude of the current that needs to be supplied to the electromagnet or electromagnetic coil 9 in order to keep the electromagnet or electromagnetic coil 9 in the same position when the object is placed on the balance pan 7. The position of the electromagnet or electromagnetic coil 9 (or another part of the electronic balance 1 that moves with the electromagnet or electromagnetic coil 9) can be determined or directly measured with high precision using a photodiode and a light source (not shown), for example.

The current that needs to be supplied to the electromagnet or electromagnetic coil 9 in order to keep the electromagnet or electromagnetic coil 9 in the same position when the object is placed on the balance pan 7 is therefore directly related to the weight of the object, and can be used to calculate the weight of the object.

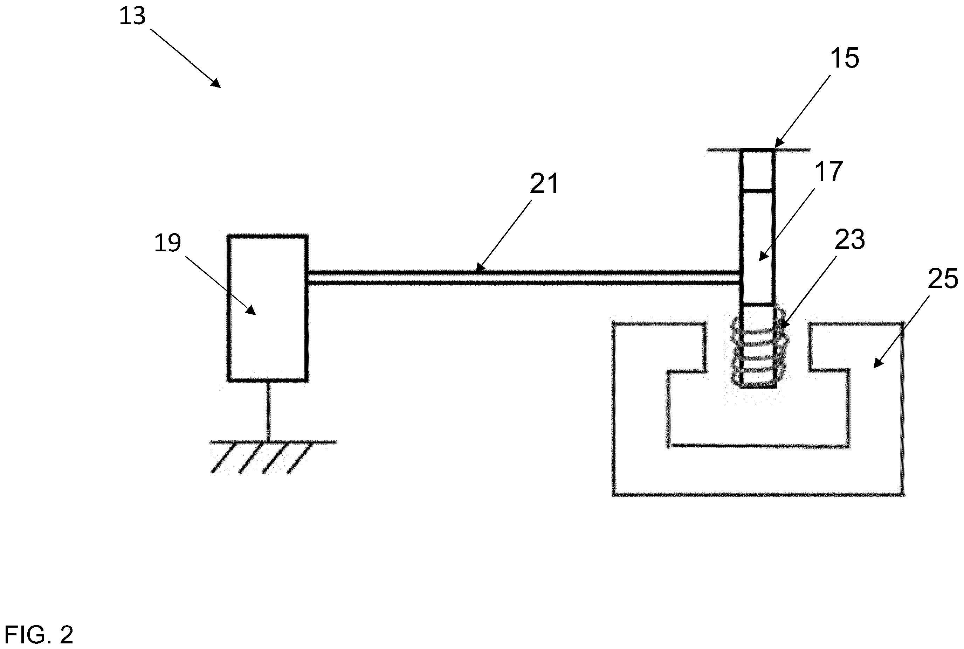

FIG. 2 is a simplified schematic illustration of the principle components of a second conventional electronic balance that can be used in embodiments of the present invention.

As shown in FIG. 2, the conventional electronic balance 13 comprises a balance pan 15 that is on a shaft 17. The shaft 17 is connected to a fixed (i.e. rigid and stationary) body 19 by a balance beam 21. The balance beam 21 is rigidly/solidly attached to the shaft 17 at one end of the balance beam 21 and is attached to the fixed body 19 by a point of flexure at the other end of the balance beam 21. The point of flexure is a point at which the balance beam 21 can flex and/or bend, e.g. in response to a load applied to the balance pan 15. For example, the point of flexure may be a narrowing in the balance beam 21.

Therefore, when a load is applied to the balance pan 15 the shaft 17 can be displaced downwards in a vertical direction by the balance beam 21 flexing or bending at the point of flexure.

An electromagnet or electromagnetic coil 23 is positioned beneath the shaft 17. However, in other embodiments the electromagnet or electromagnetic coil 23 may be positioned elsewhere. The electromagnet or electromagnetic coil 23 is located within the magnetic field of a magnet 25. The magnet 25 may be a permanent magnet, or an electromagnet.

The weighing device 13 according to this embodiment works in a similar manner to the embodiment above.

Specifically, when an object such as a semiconductor wafer is loaded on the balance pan 15, in the absence of any balancing force the balance beam 21 would flex or bend at the point of flexure, due to the moment of force caused by the weight of the object, and the balance pan 15 and shaft 17 would move downwards.

However, if a suitable current is applied to the electromagnet or electromagnetic coil 23 so that the electromagnet or electromagnetic coil 23 experiences a suitable upwards force, this downward movement of the balance pan 15 and shaft 17 can be prevented.

Therefore, the current that needs to be supplied to the electromagnet or electromagnetic coil 23 to keep the electromagnet or electromagnetic coil 23 and balance pan 15 in the same positions when the object is loaded on to the balance pan 15 is indicative of the weight of the object.

Of course, the present invention is not limited to an electronic balance as illustrated in FIG. 1 or 2, and other types or configurations of electronic balances, force sensors, force transducers, or load cells can be used in the present invention instead of the electronic balances illustrated in FIGS. 1 and 2.

As discussed above, when an object such as a wafer is loaded on the measurement pan of the electronic balance, the output of the electronic balance wanders before settling on a stable value. This stable value is different each time the wafer is loaded on the measurement pan, due to variable errors in the output of the electronic balance.

Once the output of the electronic balance has settled on the stable value, the output remains constant while the wafer is loaded on the measurement pan. Specifically, the output of the electronic balance becomes locked on the stable value.

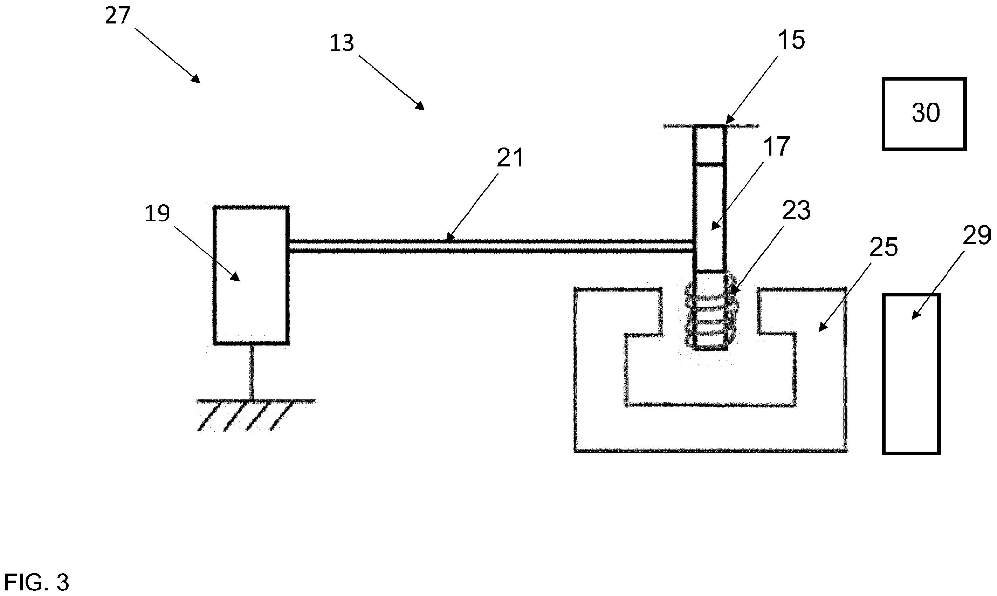

FIG. 3 shows an apparatus 27 according to an embodiment of the present invention. The apparatus includes a weighing device, which in this embodiment is the same as the electronic balance 13 illustrated in FIG. 2 and described above. The apparatus 27 may therefore include any of the features of the electronic balance 13 illustrated in FIG. 2 and/or described above. However, in other embodiments a different electronic balance or weighing device may be used instead of that illustrated in FIG. 3. For example, the weighing device may instead be as illustrated in FIG. 1, or may have a different configuration to those illustrated in FIGS. 1 and 2.

In addition, the apparatus 27 further comprises a disturbance element for disturbing an output of the electronic balance 13.

In this embodiment the disturbance element comprises an electromagnet or electromagnetic coil 29 that is located close to the electromagnet or electromagnetic coil 23 of the electronic balance 13. In FIG. 3 the electromagnet or electromagnetic coil 29 is illustrated as being positioned to the side of the electromagnet or electromagnetic coil 23. However, in other embodiments the electromagnet or electromagnetic coil 29 may instead be arranged around the electromagnet or electromagnetic coil 23 or positioned elsewhere near the electromagnet or electromagnetic coil 23.

When the electromagnet or electromagnetic coil 29 is sufficiently energised while the wafer (or other object) is loaded on the electronic balance 13, the output reading from the electromagnet or electromagnetic coil 23 is disturbed. This causes the output of the electronic balance 13 to change from the settled value.

When the electromagnet or electromagnetic coil 29 is subsequently deenergised, the output of the electronic balance 13 settles back to a new settled value, which is different to the initial settled value due the variable errors in the output of the electronic balance 13.

The time taken to disturb the measurement output of the weighing device in this manner is significantly less than the time required to remove the wafer from the electronic balance 13, wait for the output of the electronic balance 13 to return to zero, reload the wafer on the electronic balance 13 and then wait for the output to settle on a new value.

The current and duration of the energisation of the electromagnetic coil 29 are optimised to create enough disturbance to generate a new weight reading whilst minimising the time to recovery required for a new weight reading.

The apparatus may comprise a controller for selectively and/or temporarily energising (or configured to selectively and/or temporarily energise) the electromagnet or electromagnetic coil 29 so as to disturb the measurement output of the electronic balance while the object is loaded on the electronic balance.

By repeatedly disturbing the measurement output of the weighing device 13 and outputting the new settled value, a plurality of different settled values can be generated. The plurality of settled values can then be averaged to reduce or remove a variable error in the output of the electronic balance 13.

For example, the apparatus 27 may comprise a controller 30 that is configured to control the apparatus 27 to perform the steps of: recording a stable measurement output of the weighing device with the object loaded on the weighing device; controlling the disturbance element to temporarily disturb the measurement output of the weighing device with the object loaded on the weighing device by temporarily energising the electromagnet or electromagnetic coil 29; and recording a subsequent stable measurement output of the weighing device with the object loaded on the weighing device.

The controller may be configured to average the recorded stable measurement outputs.

The controller may be configured to perform the steps of controlling the disturbance element to temporarily disturb the measurement output of the weighing device with the object loaded on the weighing device, and recording a subsequent stable measurement output of the weighing device with the object loaded on the weighing device, a plurality of times to record a plurality of the subsequent stable measurement outputs.

The controller may be configured to average some or all of the stable measurement output and the subsequent stable measurement outputs.

In this manner, a more accurate measurement output can be obtained while minimising the time required to obtain the plurality of measurements. This can therefore improve the throughput of wafers.

Instead of an electromagnet or electromagnetic coil 29, the disturbance element in this embodiment may be a permanent magnet, wherein the permanent magnet is moveable closer to the electromagnet or electromagnetic coil 23, and further away from the electromagnet or electromagnetic coil 23, to vary a magnetic field of the permanent magnet experienced by the electromagnet or electromagnetic coil 23.

The electromagnet or electromagnetic coil 29 in the apparatus 27 is merely one example of a disturbing means that can be used in the present invention, and as discussed above many different types of disturbance element can be used in the present invention. These include, but are not limited to: loading additional weight onto the weighing device internally or externally; supporting part of the weight of the wafer (or other object) or applying a force to the wafer to increase the loading force on the weighing device; blowing air at or on the wafer; disturbing air in a measurement chamber of the weighing device, for example by opening and closing a lid of the measurement chamber; physically moving or vibrating some or all of the weighing device or the wafer, for example moving or vibrating an electromagnet or electromagnetic coil in the weighing device; interrupting a power supply to the weighing device; resetting or interrupting a loadcell stability algorithm of the weighing device; or disturbing a position sensor of the weighing device, for example a position sensor that detects a position of an electromagnet or electromagnetic coil in the weighing device.

The specific type of disturbance element is not essential to the present invention. Instead, it is merely necessary that the disturbance element causes a sufficient disturbance to change the output of the weighing device from the settled value while the wafer (or other object) is loaded on the weighing device.

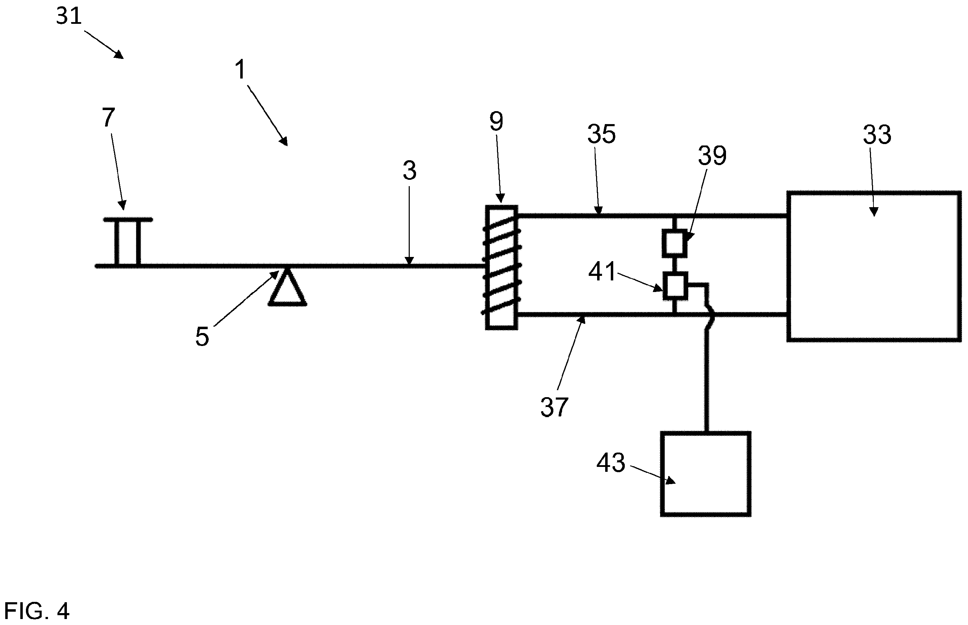

An apparatus 31 according to a further embodiment of the present invention is illustrated in FIG. 4. The apparatus 31 includes a weighing device, which in this embodiment is the same as the electronic balance 1 illustrated in FIG. 1 and described above. The apparatus 31 may therefore include any of the features of the electronic balance 1 illustrated in FIG. 1 and/or described above. However, in other embodiments a different electronic balance or weighing device may be used instead of that illustrated in FIG. 1. For example, the weighing device may instead be as illustrated in FIG. 2, or may have a different configuration to those illustrated in FIGS. 1 and 2.

The magnet 11 of the electronic balance 1 is not illustrated in FIG. 4, but is included in the electronic balance 1 in this embodiment.

The apparatus 31 comprises a controller 33, which may be referred to as a loadcell controller for example, for supplying current to the electromagnet or electromagnetic coil 9. For example, the controller 33 may be connected to the electromagnet or electromagnetic coil 9 by a circuit, for example via wires 35 and 37, for passing a current through the electromagnet or electromagnetic coil 9.

The controller 33 and/or the circuit (for example wires 35 and 37) may be part of the weighing device 1. Alternatively, the controller 33 and/or the circuit may be external to the weighing device 1.

As described above, by applying a current with a suitable magnitude and direction to the electromagnet or electromagnetic coil 9, the electromagnet or electromagnetic coil 9 can be made to experience a downwards force that causes a moment of force on the balance beam 3 that is equal and opposite to the moment of force caused by the weight of the object on the balance pan 7 (i.e. a moment of force in the clockwise direction in FIG. 4). In that case, the electromagnet or electromagnetic coil 9 will stay stationary and will not move upwards, because the two moments of force acting on the balance beam 3 cancel out, meaning that there is no resultant moment of force.

The downwards force on the electromagnet or electromagnetic coil 9, and therefore the moment of force caused by the downwards force, depends on the magnitude of the current applied to the electromagnet or electromagnetic coil 9. Therefore, the moment of force caused by the weight of the object on the balance pan 7 can be determined by measuring the magnitude of the current that needs to be supplied to the electromagnet or electromagnetic coil 9 in order to keep the electromagnet or electromagnetic coil 9 in the same position when the object is placed on the balance pan 7. The position of the electromagnet or electromagnetic coil 9 (or another part of the electronic balance that moves with the electromagnet or electromagnetic coil 9) can be determined or directly measured with high precision using a photodiode and a light source (not shown), for example.

The current that needs to be supplied to the electromagnet or electromagnetic coil 9 in order to keep the electromagnet or electromagnetic coil 9 in the same position when the object is placed on the balance pan 7 is therefore directly related to the weight of the object, and can be used to calculate the weight of the object (or information relating to the weight of the object, such as the difference between the weight of the object and a reference weight).

The apparatus 31 further comprises a load 39 (for example a resistor) connected in parallel with the electromagnet or electromagnetic coil 9 (i.e. connected between the wires 35 and 37 in parallel with the electromagnet or electromagnetic coil 9).

A switch 41 (or relay) is connected in series with the load 39. In other words, the series connection of the load 39 and the switch 41 is connected in parallel with the electromagnet or electromagnetic coil 9.

The switch 41 can be controlled to open or close by a controller 43, which may be referred to as a switch controller or relay controller. Of course, in another embodiment a single controller may perform the functions of the controllers 33 and 43. In FIG. 3 a wired connection is illustrated between the switch 41 and controller 43, but of course in other embodiments the connection may be wireless.

The load 39, switch 41 and controller 43 may correspond to a disturbance element in this embodiment.

During operation of the electronic balance 1 to perform a measurement on an object loaded on the balance pan 7, the switch 41 is controlled to be open by the controller 43 so that current cannot flow through the load 39 in parallel to the electromagnet or electromagnetic coil 9.

As discussed above, when an object such as a wafer is loaded on the balance pan 7 of the electronic balance 1, the output of the electronic balance 1 wanders before settling on a stable value. This stable value is different each time the wafer is loaded on the balance pan 7, due to variable errors in the output of the electronic balance 1.

Once the output of the electronic balance 1 has settled on the stable value, the output remains constant while the wafer is loaded on the balance pan 7. Specifically, the output of the electronic balance 1 becomes locked on the stable value.

The output of the electronic balance 1 becoming locked corresponds to the controller 33 supplying a specific, fixed current to the electromagnet or electromagnetic coil 9.

Once the output of the electronic balance 1 has settled on the stable value and the stable value has been recorded, the controller 43 is configured to control the switch 41 to close, so that current flows through the load 39 in parallel to the electromagnet or electromagnetic coil 9.

This means that less current will flow through the electromagnet or electromagnetic coil 9, and the electromagnet or electromagnetic coil 9 will therefore no longer be maintained in the same position. Movement of the electromagnet or electromagnetic coil 9 will be detected, for example as described above, and the controller 33 will respond by increasing the current supplied by the controller 33, which will disrupt the measurement output of the electronic balance 1 as described above.

Once the measurement output of the electronic balance 1 has been disrupted in this manner, the controller 43 is configured to control the switch 41 to open, so that current cannot flow through the load 39 in parallel to the electromagnet or electromagnetic coil 9. The measurement output of the electronic balance 1 will then wander before settling on a stable value, which may be different to the previous stable value.

This second stable value will be recorded, and the stable values can be averaged to produce an average measurement output.

The controller 43 therefore controls the switch 41 to close so as to disturb the measurement output of the electronic balance 1 while the object is loaded on the electronic balance 1.

The process of temporarily disrupting the measurement output and recording the subsequent stable measurement output may be repeated a plurality of times to produce a plurality of measurement outputs, some or all of which can then be averaged to produce an average measurement output.

For example, as described above in relation to the first embodiment, the apparatus 31 may comprise a controller (which may be the controller 43 or another controller) that is configured to control the apparatus 31 to perform the steps of: recording a stable measurement output of the weighing device with the object loaded on the weighing device; controlling the switch 41 to temporarily close to temporarily disturb the measurement output of the weighing device with the object loaded on the weighing device; controlling the switch 41 to subsequently open with the object loaded on the weighing device; and recording a subsequent stable measurement output of the weighing device with the object loaded on the weighing device.

The controller may be configured to average the recorded stable measurement outputs.

The controller may be configured to perform the steps of controlling the switch 41 to temporarily disturb the measurement output of the weighing device with the object loaded on the weighing device, and recording a subsequent stable measurement output of the weighing device with the object loaded on the weighing device, a plurality of times to record a plurality of the subsequent stable measurement outputs.

The controller may be configured to average some or all of the stable measurement output and the subsequent stable measurement outputs.

Of course, in alternative embodiments an alternative mechanism or arrangement or device or part for changing the load of the circuit for supplying current to the electromagnet or electromagnetic coil 9 may be used instead of the load 39 and switch 41. For example, a variable load, such as a variable resistor, may be included in the circuit in series or in parallel with the electromagnet or electromagnetic coil 9 and the measurement output may be disturbed by temporarily changing the load of the variable load.

In an alternative embodiment, the load 39 may be replaced with an inductor or a capacitor, or another electronic component, for example.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a, " "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.

## Claims

1. An apparatus (31) comprising:
a weighing device (1) for generating measurement output indicative of the weight of an object loaded on the weighing device (1);
**characterised in that** the apparatus (31) further comprises:
a disturbance element (29; 39, 41, 43) for temporarily disturbing the measurement output of the weighing device (1) while the object is loaded on the weighing device (1),
wherein the apparatus (31) comprises a controller (30, 33) configured to:
record a stable measurement output of the weighing device (1) with the object loaded on the weighing device (1);
control the disturbance element (29; 39, 41, 43) to temporarily disturb the measurement output of the weighing device (1) with the object loaded on the weighing device (1); and
record a subsequent stable measurement output of the weighing device (1) with the object loaded on the weighing device (1).

2. The apparatus (31) according to claim 1, wherein the weighing device (1) is for generating measurement output indicative of the weight of a semiconductor wafer loaded on the weighing device (1).

3. The apparatus (31) according to claim 1 or claim 2, wherein the disturbance element (29; 39, 41, 43) is configured to:
disturb the object loaded on the weighing device (1); and/or
disturb the weighing device (1), or part of the weighing device (1); and/or
alter a total weight loaded on the weighing device (1).

4. The apparatus (31) according to claim 1, wherein:
the weighing device (1) comprises an electromagnetic coil (23); and
the disturbance element (29) comprises a magnet or an electromagnetic coil (29) that is useable to disturb the electromagnetic coil (23) of the weighing device (1).

5. The apparatus (31) according to claim 1, wherein:
the weighing device (1) comprises a load cell; and
the disturbance element (29) comprises a magnet or an electromagnetic coil (29) that is useable to disturb the load cell.

6. The apparatus (31) according to claim 1, wherein the disturbance element comprises:
a mechanism for temporarily loading additional weight on the weighing device (1); or
a blower for blowing air at or on the object; or
a mechanism for vibrating the weighing device (1) and/or the object; or
a mechanism for mechanically disturbing the object and/or the weighing device (1); or
a device for temporarily interrupting or changing a power supply to the weighing device (1); or
a controller configured to reset or interrupt a stability algorithm of the weighing device (1).

7. The apparatus (31) according to claim 1, wherein:
the apparatus (31) or weighing device (1) comprises a measurement chamber; and
the disturbance element comprises a mechanism for disturbing air in the measurement chamber,
optionally wherein the disturbance element comprises a controller configured to temporarily open and subsequently close a lid of the measurement chamber to disturb the air in the measurement chamber.

8. The apparatus (31) according to claim 1, wherein:
the weighing device (1) comprises a position sensor for detecting a position of part of the weighing device (1); and
the disturbance element comprises a mechanism for optically or mechanically disturbing the position sensor.

9. The apparatus (31) according to claim 1, wherein:
the weighing device (1) comprises a load cell;
the apparatus (31) comprises a circuit (35, 37) for suppling power to the load cell; and
the disturbance element (39, 41, 43) comprises a mechanism for temporarily changing an electrical property of the circuit (35, 37),
optionally wherein the disturbance element (39, 41, 43) comprises a mechanism for temporarily changing a load, a resistance, a capacitance or an inductance of the circuit.

10. The apparatus (31) according to claim 1 or claim 9, wherein:
the weighing device (1) comprises a load cell; and
the disturbance element (39, 41, 43) comprises an electronic component (39) and a switch (41) that are connected in parallel to the load cell,
optionally wherein the electronic component (39) comprises a load, a resistor, a capacitor, or an inductor.

11. The apparatus (31) according to any one of the previous claims, wherein the controller is configured to:
repeat the steps of controlling the disturbance element (29; 39, 41, 43) and recording the subsequent stable measurement output a plurality of times; and
average at least some of the stable measurement output and the subsequent stable measurement outputs.

12. The apparatus (31) according to any one of the previous claims, wherein:
the weighing device (1) is an electronic balance; and/or
the weighing device (1) is, or comprises, a weighing balance; and/or
the weighing device (1) comprises a load cell.

13. The apparatus (31) according to any one of the previous claims, wherein the apparatus (31) comprises a controller (30) configured to calculate the mass of the object based on the measurement output,
optionally wherein the controller (30) is configured to convert the measurement output to a mass value via the application of a buoyancy calculation.

14. A method comprising:
using a weighing device (1) to generate a stable measurement output indicative of the weight of an object loaded on the weighing device (1); and
recording the stable measurement output,
**characterised in that** the method further comprises:
temporarily disturbing the measurement output of the weighing device (1) while the object is loaded on the weighing device (1);
using the weighing device (1) to generate a subsequent stable measurement output indicative of the weight of the object loaded on the weighing device (1); and
recording the subsequent stable measurement output.

## Patentansprüche

1. Vorrichtung (31), umfassend:
eine Wägevorrichtung (1) zum Erzeugen einer Messausgabe, die das Gewicht eines auf die Wägevorrichtung (1) geladenen Gegenstands angibt;
**dadurch gekennzeichnet, dass** die Vorrichtung (31) ferner Folgendes umfasst:
ein Störungselement (29; 39, 41, 43) zum vorübergehenden Stören der Messausgabe der Wägevorrichtung (1), während der Gegenstand auf die Wägevorrichtung (1) geladen wird,
wobei die Vorrichtung (31) eine Steuerung (30, 33) umfasst, die für Folgendes ausgelegt ist:
Aufzeichnen einer stabilen Messausgabe der Wägevorrichtung (1), wobei der Gegenstand auf die Wägevorrichtung (1) geladen ist;
Steuern des Störungselements (29; 39, 41, 43) zum vorübergehenden Stören der Messausgabe der Wägevorrichtung (1), wobei der Gegenstand auf die Wägevorrichtung (1) geladen ist;
Aufzeichnen einer darauffolgenden stabilen Messausgabe der Wägevorrichtung (1), wobei der Gegenstand auf der Wägevorrichtung (1) geladen ist.

2. Vorrichtung (31) nach Anspruch 1, wobei die Wägevorrichtung (1) dem Erzeugen einer Messausgabe dient, welche das Gewicht eines auf die Wägevorrichtung (1) geladenen Halbleiterwafers angibt.

3. Vorrichtung (31) nach Anspruch 1 oder Anspruch 2, wobei das Störungselement (29; 39, 41, 43) für Folgendes ausgelegt ist:
Stören des auf die Wägevorrichtung (1) geladenen Gegenstands; und/oder
Stören der Wägevorrichtung (1) oder einen Teil der Wägevorrichtung (1); und/oder
Ändern eines Gesamtgewichts, das auf die Wägevorrichtung (1) geladen ist.

4. Vorrichtung (31) nach Anspruch 1, wobei:
die Wägevorrichtung (1) eine elektromagnetische Spule (23) umfasst; und
das Störungselement (29) einen Magneten oder eine elektromagnetische Spule (29) umfasst, der/die verwendbar ist, um die elektromagnetische Spule (23) der Wägevorrichtung (1) zu stören.

5. Vorrichtung (31) nach Anspruch 1, wobei:
die Wägevorrichtung (1) eine Wägezelle umfasst; und
das Störungselement (29) einen Magneten oder eine elektromagnetische Spule (29) umfasst, der/die verwendbar ist, um die Wägezelle zu stören.

6. Vorrichtung (31) nach Anspruch 1, wobei das Störungselement Folgendes umfasst:
einen Mechanismus zum vorübergehenden Beladen von zusätzlichem Gewicht auf die Wägevorrichtung (1); oder
ein Gebläse zum Blasen von Luft an den oder auf den Gegenstand; oder
einen Mechanismus zum In-Schwingung-Versetzen der Wägevorrichtung (1) und/oder des Gegenstands; oder
einen Mechanismus zum mechanischen Stören des Gegenstands und/oder der Wägevorrichtung (1); oder
eine Vorrichtung zum vorübergehenden Unterbrechen oder Ändern einer Leistungszufuhr zu der Wägevorrichtung (1); oder
eine Steuerung, die dazu ausgelegt ist, einen Stabilitätsalgorithmus der Wägevorrichtung (1) zurückzusetzen oder zu unterbrechen.

7. Vorrichtung (31) nach Anspruch 1, wobei:
die Vorrichtung (31) oder Wägevorrichtung (1) eine Messkammer umfasst; und
das Störungselement einen Mechanismus zum Stören von Luft in der Messkammer umfasst,
wobei das Störungselement gegebenenfalls eine Steuerung umfasst, die dazu ausgelegt ist, einen Deckel der Messkammer vorübergehend zu öffnen und anschließend zu schließen, um die Luft in der Messkammer zu stören.

8. Vorrichtung (31) nach Anspruch 1, wobei:
die Wägevorrichtung (1) einen Positionssensor zum Detektieren einer Position eines Teils der Wägevorrichtung (1) umfasst; und
das Störungselement einen Mechanismus zum optischen oder mechanischen Stören des Positionssensors umfasst.

9. Vorrichtung (31) nach Anspruch 1, wobei:
die Wägevorrichtung (1) eine Wägezelle umfasst;
die Vorrichtung (31) eine Schaltung (35, 37) zum Zuführen von Leistung zu der Wägezelle umfasst; und
das Störungselement (39, 41, 43) einen Mechanismus zum vorübergehenden Ändern einer elektrischen Eigenschaft der Schaltung (35, 37) umfasst,
wobei das Störelement (39, 41, 43) einen Mechanismus zum vorübergehenden Ändern einer Last, eines Widerstands, einer Kapazität oder einer Induktanz der Schaltung umfasst.

10. Vorrichtung (31) nach Anspruch 1 oder Anspruch 9, wobei:
die Wägevorrichtung (39, 41, 43) eine elektronische Komponente (39) und einen Schalter (41) umfasst, die parallel zu der Wägezelle angeschlossen sind,
wobei die elektronische Komponente (39) gegebenenfalls eine Last, einen Widerstand, einen Kondensator oder einen Induktor umfasst.

11. Vorrichtung (31) nach einem der vorangegangenen Ansprüche, wobei die Steuerung für Folgendes ausgelegt ist:
Wiederholen der Schritte des Steuerns des Störungselements (29; 39, 41, 43) und Aufzeichnen der darauffolgenden stabilen Messausgabe eine Vielzahl von Malen; und
Mitteln zumindest eines Teils der stabilen Messausgabe und der darauffolgenden stabilen Messausgaben.

12. Vorrichtung (31) nach einem der vorangegangenen Ansprüche, wobei:
die Wägevorrichtung (1) eine elektronische Waage ist; und/oder
die Wägevorrichtung (1) eine Waage ist oder umfasst; und/oder
die Wägevorrichtung (1) eine Wägezelle umfasst.

13. Vorrichtung (31) nach einem der vorangegangenen Ansprüche, wobei die Vorrichtung (31) eine Steuerung (30) umfasst, die dazu ausgelegt ist, die Masse des Gegenstands basierend auf der Messausgabe zu berechnen,
wobei die Steuerung (30) gegebenenfalls dazu ausgelegt ist, um die Messausgabe mittels Anwendung einer Auftriebsberechnung in einen Massewert umzuwandeln.

14. Verfahren, umfassend:
Verwenden einer Wägevorrichtung (1) zum Erzeugen einer stabilen Messausgabe, welche das Gewicht eines auf die Wägevorrichtung (1) geladenen Gegenstand angibt; und
Aufzeichnen der stabilen Messausgabe,
**dadurch gekennzeichnet, dass** das Verfahren ferner Folgendes umfasst:
vorübergehendes Stören der Messausgabe der Wägevorrichtung (1), während der Gegenstand auf die Wägevorrichtung (1) geladen wird;
Verwenden der Wägevorrichtung (1), um eine darauffolgende stabile Messausgabe zu erzeugen, welche das Gewicht des auf die Wägevorrichtung (1) geladenen Gegenstands angibt; und
Aufzeichnen der darauffolgenden stabilen Messausgabe.

## Revendications

1. Appareil (31), comprenant :
un dispositif de pesage (1) pour générer une sortie de mesure indicative du poids d'un objet chargé sur le dispositif de pesage (1) ;
**caractérisé en ce que** l'appareil (31) comprend en outre :
un élément de perturbation (29 ; 39, 41, 43) pour perturber temporairement la sortie de mesure du dispositif de pesage (1) pendant que l'objet est chargé sur le dispositif de pesage (1),
dans lequel l'appareil (31) comprend un dispositif de commande (30, 33) configuré pour :
enregistrer une sortie de mesure stable du dispositif de pesage (1) avec l'objet chargé sur le dispositif de pesage (1) ;
commander l'élément de perturbation (29 ; 39, 41, 43) pour perturber temporairement la sortie de mesure du dispositif de pesage (1) avec l'objet chargé sur le dispositif de pesage (1) ; et
enregistrer une sortie de mesure stable ultérieure du dispositif de pesage (1) avec l'objet chargé sur le dispositif de pesage (1).

2. Appareil (31) selon la revendication 1, dans lequel le dispositif de pesage (1) est destiné à générer une sortie de mesure indicative du poids d'une plaquette semiconductrice chargée sur le dispositif de pesage (1).

3. Appareil (31) selon la revendication 1 ou la revendication 2, dans lequel l'élément de perturbation (29 ; 39, 41, 43) est configuré pour :
perturber l'objet chargé sur le dispositif de pesage (1) ; et/ou
perturber le dispositif de pesage (1), ou une partie du dispositif de pesage (1) ; et/ou
modifier un poids total chargé sur le dispositif de pesage (1).

4. Appareil (31) selon la revendication 1, dans lequel :
le dispositif de pesage (1) comprend une bobine électromagnétique (23) ; et
l'élément de perturbation (29) comprend un aimant ou une bobine électromagnétique (29) qui est utilisable pour perturber la bobine électromagnétique (23) du dispositif de pesage (1).

5. Appareil (31) selon la revendication 1, dans lequel :
le dispositif de pesage (1) comprend une cellule de charge ; et
l'élément de perturbation (29) comprend un aimant ou une bobine électromagnétique (29) qui est utilisable pour perturber la cellule de charge.

6. Appareil (31) selon la revendication 1, dans lequel l'élément de perturbation comprend :
un mécanisme pour charger temporairement un poids supplémentaire sur le dispositif de pesage (1) ; ou
un ventilateur pour souffler de l'air au niveau ou sur l'objet ; ou
un mécanisme pour faire vibrer le dispositif de pesage (1) et/ou l'objet ; ou
un mécanisme pour perturber mécaniquement l'objet et/ou le dispositif de pesage (1) ; ou
un dispositif pour interrompre ou changer temporairement une alimentation électrique du dispositif de pesage (1) ; ou
un dispositif de commande configuré pour réinitialiser ou interrompre un algorithme de stabilité du dispositif de pesage (1).

7. Appareil (31) selon la revendication 1, dans lequel :
l'appareil (31) ou le dispositif de pesage (1) comprend une chambre de mesure ; et
l'élément de perturbation comprend un mécanisme pour perturber l'air dans la chambre de mesure,
facultativement dans lequel l'élément de perturbation comprend un dispositif de commande configuré pour ouvrir temporairement et fermer ultérieurement un couvercle de la chambre de mesure pour perturber l'air dans la chambre de mesure.

8. Appareil (31) selon la revendication 1, dans lequel :
le dispositif de pesage (1) comprend un capteur de position pour détecter une position d'une partie du dispositif de pesage (1) ; et
l'élément de perturbation comprend un mécanisme pour perturber optiquement ou mécaniquement le capteur de position.

9. Appareil (31) selon la revendication 1, dans lequel :
le dispositif de pesage (1) comprend une cellule de charge ;
l'appareil (31) comprend un circuit (35, 37) pour alimenter la cellule de charge ; et
l'élément de perturbation (39, 41, 43) comprend un mécanisme pour modifier temporairement une propriété électrique du circuit (35, 37),
facultativement dans lequel l'élément de perturbation (39, 41, 43) comprend un mécanisme pour changer temporairement une charge, une résistance, une capacité ou une inductance du circuit.

10. Appareil (31) selon la revendication 1 ou la revendication 9, dans lequel :
le dispositif de pesage (1) comprend une cellule de charge ; et
l'élément de perturbation (39, 41, 43) comprend un composant électronique (39) et un commutateur (41) qui sont connectés en parallèle à la cellule de charge,
facultativement dans lequel le composant électronique (39) comprend une charge, une résistance, un condensateur ou une inductance.

11. Appareil (31) selon l'une quelconque des revendications précédentes, dans lequel le dispositif de commande est configuré pour :
répéter les étapes de commande de l'élément de perturbation (29 ; 39, 41, 43) et d'enregistrement de la sortie de mesure stable ultérieure une pluralité de fois ; et
faire la moyenne d'au moins une partie de la sortie de mesure stable et des sorties de mesure stables ultérieures.

12. Appareil (31) selon l'une quelconque des revendications précédentes, dans lequel :
le dispositif de pesage (1) est une balance électronique ; et/ou
le dispositif de pesage (1) est, ou comprend, une balance ; et/ou
le dispositif de pesage (1) comprend une cellule de charge.

13. Appareil (31) selon l'une quelconque des revendications précédentes, dans lequel l'appareil (31) comprend un dispositif de commande (30) configuré pour calculer la masse de l'objet sur la base de la sortie de mesure,
facultativement dans lequel le dispositif de commande (30) est configuré pour convertir la sortie de mesure en une valeur de masse via l'application d'un calcul de flottabilité.

14. Procédé, comprenant les étapes consistant à :
utiliser un dispositif de pesage (1) pour générer une sortie de mesure stable indicative du poids d'un objet chargé sur le dispositif de pesage (1) ; et
enregistrer la sortie de mesure stable,
**caractérisé en ce que** le procédé comprend en outre les étapes consistant à :
perturber temporairement la sortie de mesure du dispositif de pesage (1) pendant que l'objet est chargé sur le dispositif de pesage (1) ;
utiliser le dispositif de pesage (1) pour générer une sortie de mesure stable ultérieure indicative du poids de l'objet chargé sur le dispositif de pesage (1) ; et
enregistrer la sortie de mesure stable ultérieure.
